# EUROPEAN PATENT APPLICATION

(11) **EP 4 776 768 A1**
(43) Date of publication of application: **15.07.2026**
(21) Application number: 25151636.5
(22) Date of filing: 14.01.2025
(51) Int. Cl.: H05K 7/20

(54) **CONNECTOR FOR CONNECTING A COOLING PLATE TO A COOLANT CIRCUIT, COOLING SYSTEM, ELECTRONIC DEVICE AND MOTOR VEHICLE**

(71) Applicant: Connaught Electronics Ltd., County Galway H54 Y276 (IE)
(72) Inventor: Cakir, Erim Taylan, Tuam, H54 Y276 (IE); Wujanicz, Stefan, Tuam, H54 Y276 (IE); Sheik, Malikferoz, 600130 Chennai (IN)
(74) Representative: Jauregui Urbahn, Kristian

(57) **Abstract**

The invention is directed at a connector (10) for connecting a cooling plate (22) to a coolant circuit, the cooling plate (22) being arranged inside a housing (20) of a device to be cooled. The connector (10) comprises a tubular outer peripheral surface (18) having a first axial end portion (12) with a first annular bead (32), which can be connected to the coolant circuit. The connector (10) comprises a second axial end portion (14) with a second annular bead (36), wherein in an arrangement of the connector (10) in which it is inserted through an opening (30) of the housing (20) into a coupling portion (28) of the cooling plate (22), the second annular bead (36) bears against a wall portion of the housing (20) in the area of the opening (30) and shields the opening (30) against an environment of the housing (20).

## Description

The invention is directed at a connector or a connecting piece for connecting a cooling plate, in particular a cooling channel of the cooling plate, of a cooling system for cooling at least one electronic component of an electronic device of a motor vehicle to a coolant circuit. Herein, the cooling plate is arranged in an interior space of a housing of the electronic device and is connectable to the coolant circuit through an opening in a housing wall of the housing. A further aspect of the invention is directed at a cooling system for cooling at least one electronic component of an electronic device of a motor vehicle, comprising at least one cooling plate, a coolant circuit and a connector. A further aspect of the invention is directed at an electronic device for a motor vehicle having at least one electronic component to be cooled and a cooling system. A further aspect of the invention is directed at a motor vehicle with an electronic device. A further aspect of the invention is directed at a method for cooling an electronic component of an electronic device of a motor vehicle.

The functionality and computing power of computing systems for vehicles increases as more and more sophisticated applications are installed in the vehicles, for example applications for driver assistance systems or other semi-automatic or fully automatic driving functions. In particular, the computing power of electronic control devices such as electronic control units (ECUs), domain control units (DCUs) or zone control units (ZPUs) of the vehicles increases, which causes an increase in the heat dissipation of electronic components of those and other devices. It is therefore known to use active cooling solutions by means of a cooling fluid or liquid for these electronic components.

In these active cooling solutions, the cooling fluid or liquid (short: coolant) typically circulates within a cooling plate or within one or more cooling channels of such a cooling plate, which is in thermal contact with the electronic component(s) to be cooled. In order to provide the thermal contact, the cooling plate is typically arranged together with the electronic component(s) to be cooled inside an interior space of a housing of the electronic device. Preferably, the housing also offers space for arranging a printed circuit board (PCB) and other electronic components and/or connecting interfaces for connecting the electronic device to a communication network of the vehicle.

For practical reasons, a liquid supply for supplying the coolant to the cooling plate, in particular a cooling circuit, is not arranged inside the interior space of the housing, but outside of the housing, in particular in an environment of the housing. Therefore, there has to be an opening in a housing wall of the housing for connecting the cooling plate to the cooling circuit. It goes without saying, that openings of any kind pose a risk for contamination of the housing interior space and the electronic components arranged therein.

US 2003/0121691 A1 describes a connector cover for providing a water shield between a pipe and a connector.

It is an object of the present invention to provide measures against contamination of a housing interior space of a housing for a liquid-cooled electronic device.

The object is solved by the subject matters of the independent patent claims. Advantageous further embodiments of the invention are described by the dependent patent claims, the following description and the figures.

The invention is directed at a connector or a connecting piece for connecting a cooling plate of a cooling system for cooling at least one electronic component of an electronic device of a motor vehicle to a coolant circuit, wherein the cooling plate may receive a cooling liquid or coolant from the coolant circuit. The cooling plate may comprise an interior with one or more cooling channels and/or one or more directing elements for directing a flow of the coolant within the cooling plate.

The cooling plate according to the invention is arranged in an interior space of a housing of the electronic device and is connectable to the coolant circuit through an opening in a housing wall of the housing. In other words, the housing of the electronic device comprises the opening, wherein the cooling plate itself is arranged together with the electronic component(s) to be cooled inside the interior space of the housing. Thus, good thermal contact between the electronic component(s) and the cooling plate is ensured, while the cooling plate can easily be connected to the cooling circuit, which is arranged outside the housing or in an environment of the housing.

The cooling plate is connected to the coolant circuit by means of the connector, which comprises a tubular outer peripheral surface having a first axial end portion and a second axial end portion disposed opposite to the first axial end portion. The first axial end portion comprises a first annular bead extending in a radial direction from the outer circumferential surface at the first axial end portion and being adapted to form a connection with a coupling portion of the coolant circuit. In other words, the connector may be inserted with its first axial end portion inside the coupling portion of the coolant circuit, which may be formed as a receiving portion of a quick coupling as known from standard quick connect couplings according to SAE standards, for example SAE J2044 (SAE - Society of Automotive Engineers). By means of the first annular bead, which may be engaged with a corresponding counterpart of the coupling portion of the coolant circuit, the connector may be coupled or connected with the coolant circuit.

With the second axial end portion, the connector may be inserted into a coupling portion of the cooling plate, thus connecting the coolant circuit to the cooling plate. As the cooling plate is arranged inside the housing of the electronic device and the coolant circuit is arranged outside the housing, the second axial end portion has to be inserted through the opening inside the housing wall, in order to reach the coupling portion of the cooling plate. As the diameter of the second axial end portion may not exactly correspond to the shape and size of the opening inside the housing wall, there might exist a gap between the outer circumferential surface of the connector in the area of its second axial end portion and the inner circumferential surface of the opening, when the connector is inserted through the opening with its second axial end portion.

According to the invention, the connector comprises at its second axial end portion a second annular bead that extends in a radial direction from the outer circumferential surface at the second axial end portion of the connector, wherein in an arrangement of the connector in which it is inserted through the opening in the housing wall into the coupling portion of the cooling plate, the second annular bead bears against a wall portion of the housing of the electronic device in the area of the opening from the outside and shields the opening, in particular the gap, against the environment of the housing. In other words, the second annular bead acts as a shield for shielding the opening of the housing, in particular the gap, against contamination, in particular water or splashes of water, from the outside. When being in contact with the wall portion of the housing in the area of the opening, the second annular bead may seal the opening or the gap in a completely waterproof manner or only in a splash-proof manner, depending on its further properties.

The invention is advantageous in that it provides an easy and quick measure against contamination of a housing interior space of a housing for a liquid-cooled electronic device. The second annular bead acts as integrated shield against such contamination and is automatically placed correctly over the vulnerable opening or gap, when the connector is inserted in the coupling portion of the cooling plate. No additional component or cover must be arranged on the housing wall and adjusted for shielding the opening or the gap.

Further embodiments of the invention provide additional advantages.

According to an embodiment, the connector is formed at least partially, in particular completely, from a metal, wherein the first and/or the second annular bead is also formed at least partially, in particular completely, from the metal. Preferably, the metal is aluminum. In other words, parts of the connector, including the first and second axial end portions and preferably also the first and/or the second annular bead, may be formed of the same material, which preferably is a metal. The use of a metal for the connector parts is advantageous in that metal is a mechanically stable material, which is easy to manufacture and allows a cost-saving application.

According to a further embodiment, at least the first and/or the second annular bead is at least partially formed from a polymer, for example from rubber or plastic. In other words, the connector may also be a multi-material component, wherein in particular the first and/or the second bead may be injection molded to the first and second axial end portions, which may be formed of or comprise the metal, in particular aluminum. A rubber second annular bead is especially advantageous in that it may seal the opening or the gap more tightly than a metal bead.

Preferably, the connector is formed integrally with the first and/or the second annular bead. In other words, the connector with the first and/or the second annular bead is formed as one piece. For example, the connector as a whole can be punched out of a metal sheet and then formed into a tube in a single metal-forming production step.

According to a further embodiment, the first and/or second annular bead is formed by a respective fold in the outer peripheral surface of the connector, with a fold axis of the fold extending in a radial direction away from the outer peripheral surface. Before the forming step described above, the connector sheet can be compressed in the axial direction so that folds form in the areas where the beads are to be formed. In other words, the folds produced in this way form the beads. This type of production is cost-effective and quick to implement. It is particularly suitable for mass production. As an alternative, at least one of the beads may be formed as a welding seam or soldered around the outer circumferential surface of the connector tube.

According to a further embodiment, the connector comprises a constant cross-section in the axial direction at least between the first and second annular beads. The first and second annular beads may be spaced apart from each other according to a predetermined minimum distance, which may depend on a diameter of the connector.

According to a further embodiment, the connector may comprise an inlet portion for inserting the connector into the coupling portion of the cooling plate, wherein, when viewed from the first annular bead, the inlet portion is arranged in the axial direction beyond the second annular bead, and a cross-section of the connector tapers in the inlet portion. This facilitates easy coupling of the inlet portion with the coupling portion of the cooling plate.

Preferably, at least in the inlet portion, the connector is formed from a polymer, for example plastic or rubber. This facilitates easy coupling of the inlet portion to the coupling portion of the cooling plate and safe liquid-tight sealing of the connection between the coolant circuit and the cooling plate.

According to a further embodiment, the first and second annular beads are spaced apart from each other along the outer peripheral surface by a distance dependent on a diameter of the connector. This ensures that a predetermined distance between the coolant circuit coupling portion and the housing of the electronic component is kept at all times.

A further aspect of the invention is directed at a cooling system for cooling at least one electronic component of an electronic device of a motor vehicle, comprising at least one cooling plate, a coolant circuit and a connector according to any of above-described embodiments, the cooling plate being connected to the coolant circuit by the connector, which is inserted with its first axial end portion into a coupling portion of the coolant circuit, on the one hand, and with its second axial end portion, in particular with an inlet portion, into a coupling portion of the cooling plate, on the other hand.

A further aspect of the invention is directed at an electronic device for a motor vehicle having at least one electronic component to be cooled and a cooling system according to the invention, wherein the cooling plate of the cooling system is arranged in an interior space of a housing of the electronic device and is coupled thermally to the electronic component, wherein the connector of the cooling system is inserted with its second axial end portion through an opening in a housing wall of the housing and bears with its second annular bead from the outside against a wall portion of the housing in the region of the opening and thus shields the opening from an environment of the housing.

Preferably, the wall portion of the housing of the electronic device comprises a groove, wherein the second annular bead of the connector is received in the groove. In other words, the second annular bead may fit inside the groove, thus improving the sealing properties.

Preferably, the electronic device is a control device for controlling at least one vehicle function of the motor vehicle, in particular an electronic control unit (ECU), which can preferably be used for motor vehicles.

In particular, a vehicle-centric, zone-oriented architecture of the electrical or electronic components of the motor vehicle can be provided for the motor vehicle. In particular, at least one main controller, for example a single main controller, can be provided in such a vehicle architecture, which can also be referred to as the main control unit or vehicle computer, and which can be designed to perform the main computing operations for vehicle-specific applications, for example autonomous driving.

The main controller may be connected to several, preferably four, zonal controllers, which may also be referred to as zone controllers, by means of signaling technology. Zonal controllers can be designed to perform less demanding computing operations compared to the main computing operations of the main controller.

For example, the electronic vehicle architecture can be divided into zones, preferably four zones, wherein a zonal controller can be provided for each zone. In particular, the main controller can be connected via the zonal controllers to other electrical and electronic components of the motor vehicle, in particular to smaller, distributed control units, as well as to a large number of sensors and actuators of the motor vehicle.

Such a vehicle-centric, zone-oriented architecture of the electrical or electronic components can be advantageous at least to the extent that they are less complex than domain-oriented architectures. In particular, the computing operations of the complex, vehicle-specific applications of distributed control units can be consolidated on a single or on a few, very powerful main controllers.

Preferably, the electronic assembly according to the invention can be a main controller of the motor vehicle. Alternatively, the electronic assembly according to the invention may be a zonal controller of the motor vehicle. Accordingly, the cooling device according to the invention can be provided for cooling the powerful electronic components of a main controller or a zonal controller.

The electronic component may in particular be a component of the ECU, in particular a SoC, a microchip, a processor, an integrated circuit or the like, wherein the powerful electronic component generates harmful waste heat during operation, which must be dissipated by means of the cooling device.

A further aspect of the invention relates to a motor vehicle comprising an electronic device according to the invention.

A further aspect of the invention is directed at a method for cooling at least one electronic component of an electronic device of a motor vehicle, wherein the electronic element is arranged inside a housing interior space of a housing of the electronic device and is in thermal contact with a cooling plate of a cooling system, wherein the cooling system further comprises a coolant circuit, which is arranged outside the housing of the electronic device.

According to the method, the electronic device and the cooling system are provided. The cooling plate of the cooling system is arranged inside the housing interior space of the housing of the electronic device, together with the at least one electronic component to be cooled. Preferably, the cooling plate can be arranged on top of the at least one electronic component, in particular with a sheet of thermal interface material between the at least one electronic component and the cooling plate.

The cooling plate may be fixed to the housing, for example via screwing fixing flanges of the cooling plate to corresponding flanges of the housing. The cooling plate may also be clipped to the housing or fastened in a similar way, which allows destruction-free disassembling, for example in order to exchange the cooling plate at a later stage. The cooling plate is arranged inside the housing such that a coupling portion of the cooling plate is arranged adjacent to an opening in one of the housing walls of the housing of the electronic device. The coupling portion of the cooling plate may be connected to one or more cooling channels inside the cooling plate. Via the coupling portion, the cooling plate, in particular the cooling channel(s), may receive a cooling liquid or coolant from the coolant circuit.

According to a further method step, a connector, comprising a first axial end portion with a first annular bead and a second axial end portion with a second annular bead, is inserted through the opening in the housing wall and is inserted, in particular with its inlet portion, into the coupling portion of the cooling plate. The connector is inserted with its second axial end portion through the opening and into the coupling portion, wherein the inlet portion of the connector may be part of the second axial end portion. In the desired assembling position, the second annular bead bears against the housing wall, which comprises the opening, from an outside of the housing. In other words, the connector is inserted through the opening from the outside of the housing until its second annular bead comes into contact with an outer surface of the housing wall, which comprises the opening. In the desired assembly position, the second annular bead seals the opening or a gap, which may be left open between an outer circumferential surface of the connector and an inner circumferential surface of the opening, when the connector is inserted through the opening.

According to a further method step, the connector may be inserted with its first axial end portion into a coupling portion of the coolant circuit, which may be formed as a standard quick connection coupling according to SAE standard SAE J2044. The first annular bead may act as a fastening component. In other words, the connector may be fastened to the coupling section of the coolant circuit by fastening the first annular bead to a corresponding fastening component inside the coupling portion of the coolant circuit. For example, the fastening component inside the coupling portion may comprise a latching lug, which may engage behind the first annular bead, when the latter is pushed far enough into the coupling portion. The fastening mechanism for fastening the connector to the coupling portion of the coolant circuit may also work like a bayonet catch, wherein the connector has to be rotated around its longitudinal axis for fastening the first annular bead to such a type of catch. In this case, it would be recommendable to fasten the connector to the coupling portion of the coolant circuit before fastening it to the coupling portion of the cooling plate inside the housing.

Then, coolant or cooling liquid may be transferred from the coolant circuit to the cooling plate in order to cool the at least one electronic component of the electronic device.

Further embodiments of the cooling system and/or the electronic device and/or the motor vehicle and/or the method according to the invention follow directly from the various embodiments of the connector according to the invention and vice versa. In particular, individual features and corresponding explanations as well as advantages relating to the various implementations of the connector according to the invention can be transferred analogously to implementations of the cooling system and/or the electronic device and/or the motor vehicle and/or the method according to the invention and vice versa.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, may also be comprised by the invention. Moreover, embodiments and combinations of features, which go beyond or deviate from the combinations of features set forth in the recitations of the claims may be comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

Embodiments of the invention are described below. In the figures:
- Fig. 1: Shows a schematic longitudinal section view of a connector according to an embodiment of the invention, which is inserted through an opening of a housing of an electronic device and connected to a cooling plate inside the housing;
- Fig. 2: Shows a schematic view of an electronic device housing with an inlet and an outlet connector according to an embodiment of the invention;
- Fig. 3: Shows a schematic exploded view of a housing with housing openings and a cooling plate to be arranged inside the housing with an inlet and an outlet connector according to an embodiment of the invention;
- Fig. 4: Shows a schematic detailed view of the inlet and outlet connectors according to Figs. 2 and 3, each sitting in a groove of the housing;
- Fig. 5: Shows a schematic view of a motor vehicle with an electronic device according to an embodiment of the invention; and
- Fig. 6: Shows a schematic view of a method for cooling at least one electronic component of an electronic device of a motor vehicle according to an embodiment of the invention.

The embodiments explained below are preferred embodiments of the invention. In the embodiments, the described components of the embodiments each represent individual features of the invention which are to be considered independently of each other, which also further form the invention independently of each other and are thus also to be regarded as part of the invention individually or in a combination other than that shown. Furthermore, the embodiment described can also be supplemented by other features of the invention already described.

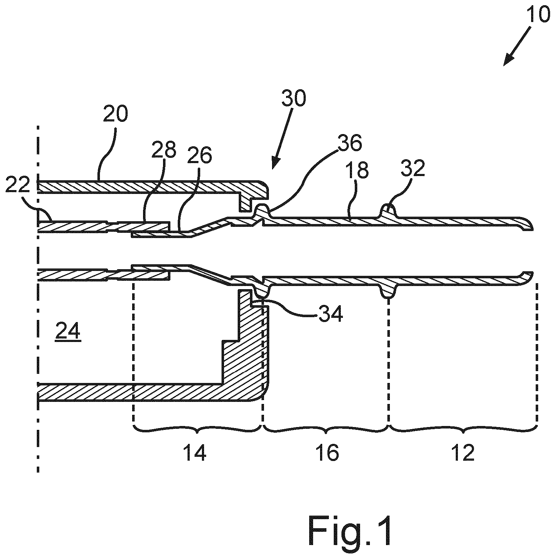

Fig. 1 shows a schematic longitudinal section view of a connector 10. The connector 10 as shown in Fig. 1 comprises at least three portions or sections: a first axial end portion 12, a second axial end portion 14 and a tubular portion 16, which extends at least between the two axial end portions 12, 14. Overall, the connector comprises a tubular shape or tubular outer peripheral or outer circumferential surface 18. In other words, the connector 10 may have the shape of a tube.

Fig. 1 further shows parts of a housing 20 and of a cooling plate 22, which is arranged in an interior space 24 of the housing 20. In Fig. 1, the connector 10 is inserted with its inlet portion 26 into a coupling portion 28 of the cooling plate 22. In order to be inserted into the coupling portion 28 of the cooling plate 22, the connector 10 has to be inserted through an opening 30 in a housing wall of the housing 20. With its second axial end portion 12, the connector 10 may be coupled to a coupling portion of a coolant circuit (not shown). For coupling, a first annular bead 32 of the connector 10, which is arranged in the area of the first axial end portion 12, may be engaged to a corresponding locking mechanism of the coupling portion of the coolant circuit, which may for example be a quick connect coupling according to SAE J2044 standard.

In the exemplary embodiment according to Fig. 1, the housing wall comprises a circumferential groove 32 around the opening 30. A second annular bead 36 of the connector 10, which is arranged in the area of the second axial end portion 14, may sit inside the groove 32, thereby sealing the opening 30 or a gap between the outer peripheral surface 18 of the connector 10 and an inner circumferential surface of the opening 30 at least in a splash-proof manner.

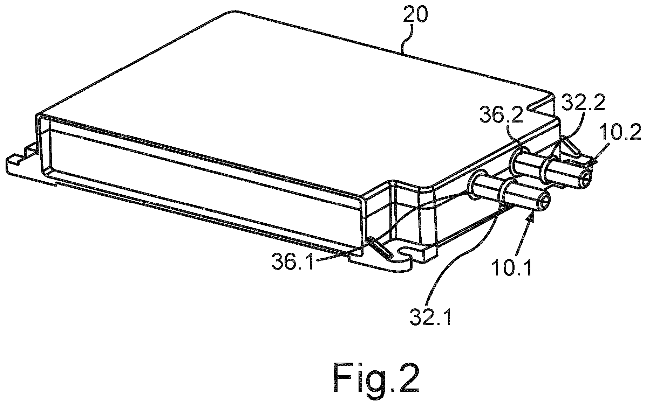

Fig. 2 shows a schematic view of an electronic device housing 20 with an inlet connector 10.1 and an outlet connector 10.2. Each of the connectors 10.1 and 10.2 comprises the elements described in the context of Fig. 1.

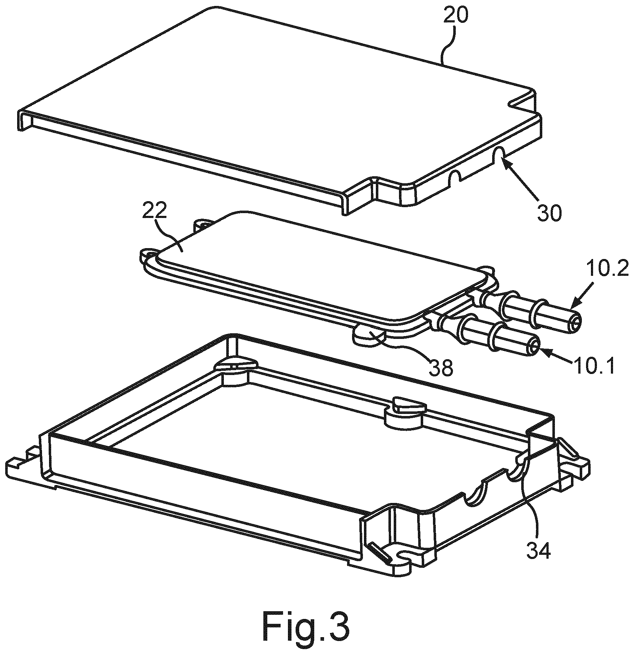

With reference to the elements shown and described in more detail in the context of Figs. 1 and 2, Fig. 3 shows a schematic exploded view of a housing 20 with housing openings 30 and a cooling plate 22 to be arranged inside the housing 20 with an inlet connector 10.1 and an outlet connector 10.2. As can be seen from Fig. 3, the housing 20 may comprise an upper housing part and a lower housing part, wherein each of the housing parts comprises two halfmoon-shaped openings 30, wherein two the respective halfmoon-shaped openings 30 form a round opening 30 in an assembled state of the upper and the lower housing parts. Each of the openings 30 comprises a groove 34, which, for the sake of readability of the figure, is only indicated with reference sign for the right halfmoon-shaped opening 30 in the lower housing part.

The cooling plate 22 may be fastened to the housing 20 via a fastening portion 38, which may for example be clipped to an inner wall of the housing 20.

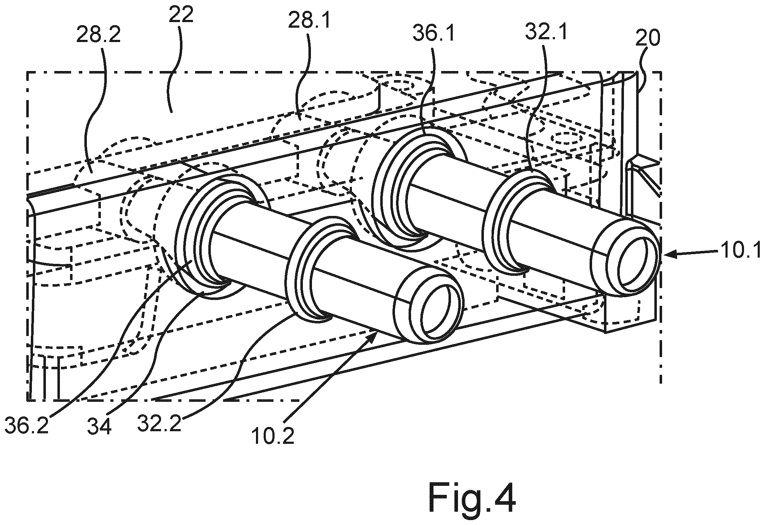

Fig. 4 shows, with reference to what has already been described in the context of the preceding figures, a schematic detailed view of the inlet connector 10.1 and the outlet connector 10.2, as they are coupled to respective coupling portions 28.1 and 28.2 of the cooling plate 22. The coupling portions 28.1 and 28.2 are visible in Fig. 4 due to the half-transparent display of the upper housing part.

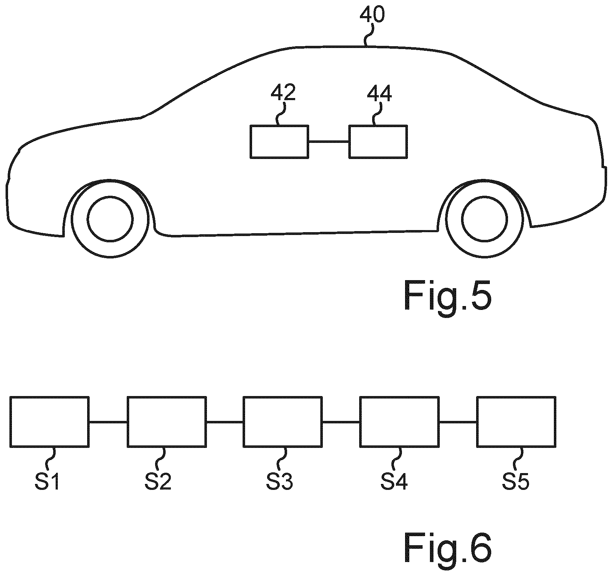

Fig. 5 shows a schematic view of a motor vehicle 40 with an electronic device 42, which may be coupled to a cooling system 44 for cooling at least one electronic component of the electronic device 42 of the motor vehicle 40. The cooling system 44 may comprise at least one cooling plate 22, a coolant circuit (not shown) and a connector 10. The cooling plate 22 may be connected to the coolant circuit by the connector 10, which is inserted with its first axial end portion 12 into a coupling portion of the coolant circuit, on the one hand, and with its second axial end portion 14, in particular with an inlet portion 26, into a coupling portion 28 of the cooling plate 22, on the other hand.

The electronic device 42 may be a control device for controlling at least one vehicle function of the motor vehicle 40.

Fig. 6 shows a schematic view of a method for cooling at least one electronic component of an electronic device 42 of a motor vehicle 40, wherein the electronic element is arranged inside a housing interior space 24 of a housing 20 of the electronic device 42 and is in thermal contact with a cooling plate 22 of a cooling system 44, wherein the cooling system 44 further comprises a coolant circuit, which is arranged outside the housing 20 of the electronic device 42.

According to a method step S1, the electronic device 42 and the cooling system 44 are provided. The cooling plate 22 of the cooling system is arranged inside the housing interior space 24 of the housing 20 of the electronic device 42, together with the at least one electronic component to be cooled. Preferably, the cooling plate 22 can be arranged on top of the at least one electronic component, in particular with a sheet of thermal interface material between the at least one electronic component and the cooling plate 22.

In a step S2, the cooling plate 22 may be fixed to the housing 20, for example via screwing fixing flanges of the cooling plate 22 to corresponding flanges of the housing 20. The cooling plate 22 may also be clipped to the housing 20 or fastened in a similar way, which allows destruction-free disassembling, for example in order to exchange the cooling plate 22 at a later stage. The cooling plate 22 is arranged inside the housing 20 such that a coupling portion 28 of the cooling plate 22 is arranged adjacent to an opening 30 in one of the housing walls of the housing 20 of the electronic device 42. The coupling portion 28 of the cooling plate 22 may be connected to one or more cooling channels inside the cooling plate 22. Via the coupling portion 28, the cooling plate 22, in particular the cooling channel(s), may receive a cooling liquid or coolant from the coolant circuit.

According to a step S3, a connector 10, comprising a first axial end portion 12 with a first annular bead 32 and a second axial end portion 14 with a second annular bead 36, is inserted through the opening 30 in the housing wall and is inserted, in particular with its inlet portion 26, into the coupling portion 28 of the cooling plate 22. The connector 10 is inserted with its second axial end portion 14 through the opening 30 and into the coupling portion 28, wherein the inlet portion 26 of the connector 10 may be part of the second axial end portion 14. In the desired assembling position, the second annular bead 36 bears against the housing wall, which comprises the opening 30, from an outside of the housing 30. In other words, the connector 10 is inserted through the opening 30 from the outside of the housing 20 until its second annular bead 36 comes into contact with an outer surface of the housing wall, which comprises the opening 30. In the desired assembly position, the second annular bead 36 seals the opening 30 or a gap, which may be left open between an outer circumferential surface 18 of the connector 10 and an inner circumferential surface of the opening 30, when the connector 10 is inserted through the opening 30.

According to a method step S4, the connector 10 may be inserted with its first axial end portion 12 into a coupling portion of the coolant circuit, which may be formed as a standard quick connection coupling according to SAE standard SAE J2044. The first annular bead 32 may act as a fastening component. In other words, the connector 10 may be fastened to the coupling portion of the coolant circuit by fastening the first annular bead 32 to a corresponding fastening component inside the coupling portion of the coolant circuit.

For example, the fastening component inside the coupling portion of the coolant circuit may comprise a latching lug, which may engage behind the first annular bead 32, when the latter is pushed far enough into the coupling portion. The fastening mechanism for fastening the connector 10 to the coupling portion of the coolant circuit may also work like a bayonet catch, wherein the connector 10 has to be rotated around its longitudinal axis for fastening the first annular bead 32 to such a type of catch. In this case, it would be recommendable to fasten the connector 10 to the coupling portion of the coolant circuit before fastening it to the coupling portion 28 of the cooling plate 22 inside the housing 30 (step S3).

In a step S5, coolant or cooling liquid may be transferred from the coolant circuit to the cooling plate 22 in order to cool the at least one electronic component of the electronic device 42.

Cold plates or cooling plates typically are standalone components which are not integrated into a housing of an electronic device as in friction stir welded (FSW) cooling applications, where a cooling chamber may be an integral part of the housing. Therefore, if an electronic component of such an electronic device needs cooling by a cooling plate, the cooling plate has to be connected to a coolant circuit external to the housing. The connection therefore has to go through an opening in the housing wall. Such an opening typically requires a water/splash proof design, to avoid contamination of the housing interior. Such a design can be achieved by shielding the interface between the housing and cold plate inlet/outlet fittings or connectors.

Standard SAE type fittings or couplings for liquid cooling systems include only one bead. This bead provides connection and mounting interface to mating coupling or to a coupling portion of the coolant circuit. In the proposed solution, a second bead/flange is added behind the first one, preferably by keeping a minimum distance that is recommended on SAE standard, to provide a splash-proof feature between the housing and the cold plate by keeping inlet/outlet fittings outside of the housing.

This additional bead/flange eliminates additional part requirement in the assembly such as grommet, or any similar type of component to provide splash-proof interface between housing and cooling plate fittings. The invention provides an easy process to add this part/bead on fittings and is cost effective instead of using additional components.

There are also friction stir welded (FSW) cooling applications in the market for ECU cooling to provide a sealed interface between cooling fittings. However, the proposed design provides a solution for cold plate applications, for example in liquid cooled ECUs.

The standard SAEJ2044 automotive type fittings include only one bead as shown for mating coupling connection and there is no splash-proof feature in standard application. The proposed design provides a splash-proof feature between housing parts and cold plate by keeping inlet/outlet fittings outside of the housing as shown in Fig. 1. Standard SAE type fittings or couplings for liquid cooling systems include only one bead and this bead provides connection and mounting interface to mating coupling. The second bead or flange that is added in the proposed design in particular is keeping a minimum distance that is recommended on SAE standard depending on pipe diameter. The housing part includes a groove to place this fitting and keeping the second bead to provide a splash-proof feature between a housing and cold plate inlet/outlet fitting.

The applications that are seen in the market include FSW plates to provide a sealed interface between cooling fittings and housing or using an additional component such as grommet, or any similar type of component. The additional component can be avoided by using the proposed design.

Overall, the examples show, how measures against contamination of a housing interior space of a housing for a liquid-cooled electronic device can be provided.

## Claims

1. Connector (10) for connecting a cooling plate (22) of a cooling system (44) for cooling at least one electronic component of an electronic device (42) of a motor vehicle (40) to a coolant circuit, wherein the cooling plate (22) is arranged in an interior space (24) of a housing (20) of the electronic device (42) and is connectable to the coolant circuit through an opening (30) in a housing wall of the housing (20), wherein
- the connector (10) comprises a tubular outer circumferential surface (18) having a first axial end portion (12) and a second axial end portion (14) disposed opposite to the first axial end portion (12),
- the first axial end portion (12) comprises a first annular bead (32) extending in a radial direction from the outer circumferential surface (18) at the first axial end portion (12) and being adapted to form a connection with a coupling portion of the coolant circuit,
**characterized in that**
the connector (10) comprises at its second axial end portion (14) a second annular bead (36) that extends in a radial direction from the outer circumferential surface (18) at the second axial end portion (14) of the connector (10), wherein
- in an arrangement of the connector (10) in which it is inserted through the opening (30) in the housing wall into a coupling portion (28) of the cooling plate (22), the second annular bead (36) bears against a wall portion of the housing (20) of the electronic device (42) in the area of the opening (30) from the outside and shields the opening (30) against an environment of the housing (20).

2. Connector (10) according to claim 1, wherein the connector (10) is formed at least partially, in particular completely, from a metal, wherein the first and/or the second annular bead (12, 14) is also formed at least partially, in particular completely, from the metal.

3. Connector (10) according to claim 2, wherein the metal is aluminum.

4. Connector (10) according to any of the preceding claims, wherein the first and/or the second annular bead (12, 14) is at least partially formed from a polymer.

5. Connector (10) according to any of the preceding claims, wherein the connector (10) is formed integrally with the first and/or the second annular (12, 14) bead.

6. Connector (10) according to any of the preceding claims, wherein the first and/or second annular bead (12, 14) is formed by a respective fold in the outer peripheral surface (18) of the connector (10), with a fold axis of the fold extending in a radial direction away from the outer peripheral surface (18).

7. Connector (10) according to any of the preceding claims, wherein the connector (10) comprises a constant cross-section in the axial direction at least between the first and second annular beads (12, 14).

8. Connector (10) according to any of the preceding claims, comprising an inlet portion (26), wherein, when viewed from the first annular bead (12), the inlet portion (26) is arranged in the axial direction beyond the second annular bead (14), and a cross-section of the connector (10) tapers in the area of the inlet portion (26).

9. Connector (10) according to claim 9, wherein in the inlet portion (26), the connector (10) is formed from a polymer.

10. Connector (10) according to any of the preceding claims, wherein the first and second annular beads (12, 14) are spaced apart from each other along the outer peripheral surface (18) by a distance dependent on a diameter of the connector (10).

11. Cooling system (44) for cooling at least one electronic component of an electronic device (42) of a motor vehicle (40), comprising at least one cooling plate (22), a coolant circuit and a connector (10) according to any of the preceding claims, the cooling plate (22) being connected to the coolant circuit by the connector (10), which is inserted with its first axial end portion (12) into a coupling portion of the coolant circuit, on the one hand, and with its second axial end portion (14), in particular with an inlet portion (26), into a coupling portion (28) of the cooling plate (22), on the other hand.

12. Electronic device (42) for a motor vehicle (40) having at least one electronic component to be cooled and a cooling system (44) according to claim 11, wherein the cooling plate (22) of the cooling system (44) is arranged in an interior space (24) of a housing (20) of the electronic device (42) and is coupled thermally to the at least one electronic component, wherein the connector (10) of the cooling system (44) is inserted with its second axial end portion (14) through an opening (30) in a housing wall of the housing (20) and bears with its second annular bead (14) from the outside against a wall portion of the housing (20) in the region of the opening (30) and thus shields the opening (30) from an environment of the housing (20).

13. Electronic device (42) according to claim 12, wherein the wall portion comprises a groove (34), in particular a circumferential groove (34) around the opening (30), wherein the second annular bead (14) of the connector (10) is received in the groove (34).

14. Electronic device (42) according to any of claims 12 or 13, wherein the electronic device (42) is a control device for controlling at least one vehicle function of the motor vehicle (40).

15. Motor vehicle (40) comprising an electronic device (42) according to any of claims 12 to 14.
